# EUROPÄISCHE PATENTANMELDUNG

(11) **EP 2 221 515 A1**
(43) Veröffentlichungstag der Anmeldung: **25.08.2010**
(21) Anmeldenummer: 09002561.0
(22) Anmeldetag: 24.02.2009
(51) Int. Cl.: F16J 15/34, C23C 16/02

(54) **Gleitringdichtung und Verfahren zur Herstellung einer solchen Gleitringdichtung**

(71) Anmelder: Grundfos Management A/S, 8850 Bjerringbro (DK)
(72) Erfinder: Grann, Helge, 8850 Bjerringbro (DK); Højsholt, Rune, 8900 Randers (DK); Nielsen, John Frigaard, 8990 Fårup (DK)
(74) Vertreter: Hemmer, Arnd

(57) **Zusammenfassung**

Die Erfindung betrifft eine Gleitringdichtung (2) mit zumindest einem ersten festen Dichtelement (4) und einem zweiten gemeinsam mit einer Welle rotierendem Dichtelement (6), wobei zumindest eines der Dichtelemente (4, 6) eine Dichtfläche (22, 24) aufweist, welche aus einer an der Oberfläche strukturierten Tragschicht (26) und einer auf der Tragschicht (26) derart aufgebrachten diamanthaltigen Deckschicht (30) gebildet ist, dass die Oberfläche der Deckschicht (30) aufgrund der Strukturierung der Tragschicht (26) entsprechend strukturiert ist sowie ein Verfahren zur Herstellung einer solchen Gleitringdichtung (2).

## Beschreibung

Die Erfindung betrifft eine Gleitringdichtung sowie ein Verfahren zur Herstellung einer solchen Gleitringdichtung.

Gleitringdichtungen werden als Wellendichtungen beispielsweise in Pumpenaggregaten eingesetzt, um den trockenen Motorraum gegenüber dem nassen Pumpenraum abzudichten. Üblicherweise weisen sie ein feststehendes Dichtelement auf, welches beispielsweise fest mit einem Gehäuse verbunden ist und ein bewegliches Dichtelement, welches fest mit der rotierenden Welle verbunden ist. Die beiden Dichtelemente sind in gleitenden Kontakt und unterliegen daher dem Verschleiß aufgrund von Reibung. Ein besonders hoher Verschleiß ergibt sich in Pumpenaggregaten, welche Medien mit hoher Temperatur, beispielsweise heißes Wasser von mehr als 100 °C fördern. Da das Wasser verdampft, kann eine ausreichende Schmierung zwischen den Dichtelementen häufig nicht sichergestellt werden.

Es ist daher Aufgabe der Erfindung, eine verbesserte Gleitringdichtung, insbesondere zum Einsatz in einem Pumpenaggregat zu schaffen, welche auch bei hohen Temperaturen eine ausreichende Verschleißfestigkeit aufweist.

Diese Aufgabe wird gelöst durch eine Gleitringdichtung mit den im Anspruch 1 angegebenen Merkmalen sowie durch ein Verfahren zur Herstellung einer solchen Gleitringdichtung mit den im Anspruch 13 angegebenen Merkmalen. Bevorzugte Ausführungsformen ergeben sich aus den Unteransprüchen, der nachfolgenden Beschreibung sowie den beigefügten Zeichnungen.

Die erfindungsgemäße Gleitringdichtung weist zumindest ein erstes festes Dichtelement und ein zweites gemeinsam mit einer Welle rotierendes, d.h. bewegliches Dichtelement auf. Die beiden Dichtelemente sind über entsprechende Dichtflächen gleitend miteinander in Kontakt. Dabei weist zumindest eines der Dichtelemente eine Dichtfläche auf, welche aus einer an der Oberfläche strukturierten Tragschicht und einer auf der Tragschicht aufgebrachten Deckschicht gebildet ist. Die strukturierte Tragschicht sorgt dafür, dass die Oberfläche der Dichtfläche nicht glatt, sondern strukturiert ist. Die Deckschicht gibt der Oberfläche die gewünschte Oberflächeneigenschaften, insbesondere eine gewünschte Oberflächenhärte. Dazu ist die Deckschicht diamanthaltig ausgebildet. Gleichzeitig wird die Deckschicht derart gleichmäßig auf die Tragschicht aufgebracht, dass die Oberfläche der Deckschicht entsprechend der Strukturierung der Tragschicht strukturiert ist. D.h., die Deckschicht weist vorzugsweise eine gleichmäßige Dicke auf, sodass sich die Struktur der Tragschicht auch in der Oberfläche der Deckschicht abzeichnet und die Deckschicht entsprechend strukturiert ist.

Auf diese Weise lässt sich eine strukturierte, hochfest Oberfläche für die Dichtfläche ausbilden. Die Struktur vergrößert die Oberfläche des Dichtelementes, wodurch eine bessere Kühlung erreicht wird. Ferner hält sich in Vertiefungen der Struktur Flüssigkeit, beispielsweise Wasser, auch bei hohen Temperaturen. Wenn die Flüssigkeit dort dann verdampft, kommt es zu einer Abkühlung der umgebenden Oberfläche. Somit wird insgesamt durch die Strukturierung eine bessere Kühlung der Gleitringdichtung erreicht.

Die diamanthaltige Deckschicht weist eine hohe Verschleißfestigkeit auch bei hohen Temperaturen auf. Durch das Aufbringen der diamanthaltigen Deckschicht auf die strukturierte Tragschicht bzw. einen strukturierten Grundkörper ist es sehr einfach möglich, eine an der Oberfläche strukturierte bzw. profilierte diamanthaltige Schicht zu schaffen, ohne die diamanthaltige Schicht nachträglich bearbeiten zu müssen. Eine solche Bearbeitung ist nämlich nur außerordentlich schwer durchzuführen.

Die diamanthaltige Deckschicht kann durch übliche Auftragsverfahren, beispielsweise im CVD (Chemical Vapor Deposition)-Verfahren, vorzugsweise im HFCVD (Hot Filament Chemical Vapor Deposition) - Verfahren, oder im Micro Wave Chemical Vapor Deposition-Verfahren auf die Tragschicht aufgebracht werden.

Besonders bevorzugt ist es, dass das erste Dichtelement eine erste Dichtfläche aufweist und dass das zweite Dichtelement eine zweite Dichtfläche aufweist, welche jeweils aus einer an der Oberfläche strukturierten Tragschicht und einer auf der Tragschicht derart aufgebrachten diamanthaltigen Deckschicht gebildet sind, dass die Oberfläche der Deckschicht aufgrund der Strukturierung der Tragschicht entsprechend strukturiert ist. Dies bedeutet bei dieser Ausführungsform sind sowohl die erste Dichtfläche als auch die zweite Dichtfläche in der oben beschriebenen Weise ausgebildet. Die erste und die zweite Dichtfläche sind gleitend und dichtend miteinander in Anlage.

Die Tragschicht kann beispielsweise durch eine Oberflächenbearbeitung strukturiert sein. D.h., in einen Grundkörper bzw. eine Grundstruktur der Tragschicht wird durch ein geeignetes Bearbeitungsverfahren die Strukturierung eingebracht. Dies kann beispielsweise durch Laser- oder Elektronenstrahlbearbeitung, Ätzen oder geeignete mechanische Bearbeitung erfolgen.

Darüber hinaus ist es alternativ oder zusätzlich möglich, die Tragschicht aus einem porösen Material auszubilden. Ein derartiges poröses Material weist durch die zur Oberfläche hin geöffneten Poren bereits eine strukturierte Oberfläche auf. Auf diese Weise kann die erforderliche Bearbeitung reduziert oder vermieden werden.

Besonders bevorzugt ist die Tragschicht aus einem Keramikmaterial gebildet, vorzugsweise Siliziumkarbid oder Wolframkarbid. Ein solches Keramikmaterial weist selbst schon eine hohe Härte bzw. Festigkeit auf und ist darüber hinaus auch bei hohen Temperaturen formstabil. Ferner lässt sich ein solches Keramikmaterial durch einen üblichen Beschichtungsprozess, wie er oben beschrieben worden ist, mit der diamanthaltigen Deckschicht beschichten.

Die Strukturierung der Tragschicht ist bevorzugt in Form einer Vielzahl von Vertiefungen an der Oberfläche der Tragschicht ausgebildet. Diese Vertiefungen können regelmäßig oder unregelmäßig an der Oberfläche verteilt sein und beispielsweise durch eines der vorgenannten Verfahren in einen Grundkörper bzw. eine Grundstruktur der Tragschicht eingebracht sein.

Bevorzugt sind die Vertiefungen gleichmäßig über die Oberfläche verteilt. Dies schließt eine regelmäßige und auch eine zufällige Verteilung über die Oberfläche ein. Auf diese Weise wird erreicht, dass die Oberfläche der Dichtfläche an jeder Stelle die gleichen Eigenschaften aufweist. So wird eine ausreichende Schmierung und Kühlung in jedem Bereich der Dichtfläche gewährleistet.

Besonders bevorzugt bedecken die Vertiefungen 5% bis 30% der Oberfläche der Tragschicht. Auf diese Weise wird ein ausreichend großer Aufnahmeraum für Flüssigkeit zur Schmierung und Kühlung der Oberfläche bereitgestellt.

Weiter bevorzugt weisen die Vertiefungen einen Durchmesser zwischen 20 µm und 150 µm auf.

Die Vertiefungen, welche die Strukturierung an der Oberfläche der Deckschicht ausbilden, sind bevorzugt tiefer als die Dicke der Deckschicht. Dies kann dadurch erreicht werden, dass entsprechend große Vertiefungen in die Tragschicht eingebracht werden und die Tragschicht dann mit einer im Vergleich zu den Vertiefungen dünnen Deckschicht überzogen wird. Auf diese Weise können größere Vertiefungen in der Deckschicht ausgebildet werden, als es möglich wäre, wenn die Deckschicht nachträglich strukturiert würde. Dann wäre es nicht möglich in der Deckschicht Vertiefungen auszubilden, welche tiefer als die Dicke der Deckschicht sind.

Die Deckschicht besteht besonders bevorzugt aus polykristallinem Diamant. Eine solche Schicht lässt sich in der oben genannten Weise auf eine Tragschicht, beispielsweise aus Keramik aufbringen.

Es ist möglich, die erste und die zweite Dichtfläche identisch auszubilden, insbesondere identisch zu strukturieren. Alternativ ist es jedoch auch möglich die erste und zweite Dichtfläche unterschiedlich auszubilden, insbesondere mit einer unterschiedlichen Struktur an der Oberfläche zu versehen. D.h., beispielsweise kann eine Dichtfläche mehr und/oder größere Vertiefungen bzw. Poren aufweisen als die andere Oberfläche. Durch entsprechende Wahl bzw. Anpassung der zusammenwirkenden Dichtflächen kann insgesamt eine optimale Schmierung und Kühlung der Gleitringdichtung realisiert werden.

Die erfindungsgemäße Gleitringdichtung ist vorzugsweise als Wellendichtung in einer Pumpe eingesetzt. In einer Pumpe kann die Wellendichtung beispielsweise den Motorraum gegenüber dem Pumpraum, durch welchen das zu fördernde Fluid strömt abgedichtet werden.

Die Erfindung betrifft ferner ein Verfahren zur Herstellung einer Gleitringdichtung gemäß der vorangehenden Beschreibung. Gemäß dem erfindungsgemäßen Verfahren wird die Gleitringdichtung, welche vorzugsweise wie oben beschrieben ausgebildet ist, aus zwei Dichtelementen gebildet, welche gleitend miteinander in Kontakt sind. Vorzugsweise sind beide Dichtelemente in derselben nachfolgend beschriebenen Weise ausgebildet. Das zur Ausbildung des Dichtelementes wird zunächst ein Tragelement bzw. Tragschicht mit einer strukturierten Oberfläche bereitgestellt. Das Tragelement ist bevorzugt aus Keramikmaterial, wie oben beschrieben, gefertigt. Anschließend wird die strukturierte Oberfläche des Tragelementes derart gleichmäßig mit Diamant beschichtet, dass an der Oberfläche der so gebildeten diamanthaltigen Deckschicht die Strukturierung der Oberfläche des Tragelementes erhalten bleibt. D.h., die so gebildete diamanthaltige Deckschicht weist bevorzugt über die gesamte Oberfläche des Tragelementes eine im wesentlichen konstante Dicke auf, sodass sich die Struktur der unterhalb der Deckschicht gelegenen Tragschicht bzw. des Tragelements auf der Oberfläche der Deckschicht abzeichnet. Die Diamantschicht kann beispielsweise aus polykristallinem Diamant bestehen, welcher im PVD- oder beispielsweise im CVD-Verfahren auf das Tragelement aufgebracht ist.

Die Oberfläche des Tragelementes kann beispielsweise durch Ätzen, Laser- oder Elektronenstrahlbearbeitung strukturiert werden. D.h., in einem zunächst im Wesentlichen glatten Grundkörper wird an der Oberfläche die Strukturierung eingebracht.

Besonders bevorzugt wird die Strukturierung der Oberfläche des Tragelementes in der Weise erzeugt, dass das Tragelement aus einem Material mit Einschlüssen gefertigt wird und die Einschlüsse an der Oberfläche durch Ätzen abgetragen werden. Auf diese Weise werden an der Oberfläche Poren gebildet, die die Strukturierung darstellen. Ein solches Material mit Einschlüssen kann beispielsweise ein Keramikmaterial wie Siliziumkarbid oder Wolframkarbid mit Graphiteinschlüssen sein. Derartige Graphiteinschlüsse, welche vorzugsweise gleichmäßig im Inneren des Materials verteilt sind, befinden sich dann auch an der Oberfläche des Materials. Dort können Sie durch Ätzen entfernt werden, sodass dort, wo das Graphit zuvor vorhanden war, Poren bzw. Freiräume gebildet werden. Anschließend wird dann die diamanthaltige Beschichtung in der zuvor beschriebenen Weise aufgetragen.

Nachfolgend wird die Erfindung beispielhaft anhand der beigefügten Figuren beschrieben. In diesen zeigt:
- Fig. 1: eine geschnittene Gesamtansicht einer erfin- dungsgemäßen Gleitringdichtung im Einsatz,
- Fig. 2: eine vergrößerte schematische Schnittansicht der erfindungsgemäßen Gleitringdichtung,
- Fig. 3a und 3b: schrittweise die Fertigung eines Gleitelementes gemäß der Erfindung und
- Fig. 4a, 4b und 4c: schrittweise die Fertigung eines erfindungsgemä- ßen Gleitelementes mittels eines alternativen Ver- fahrens.

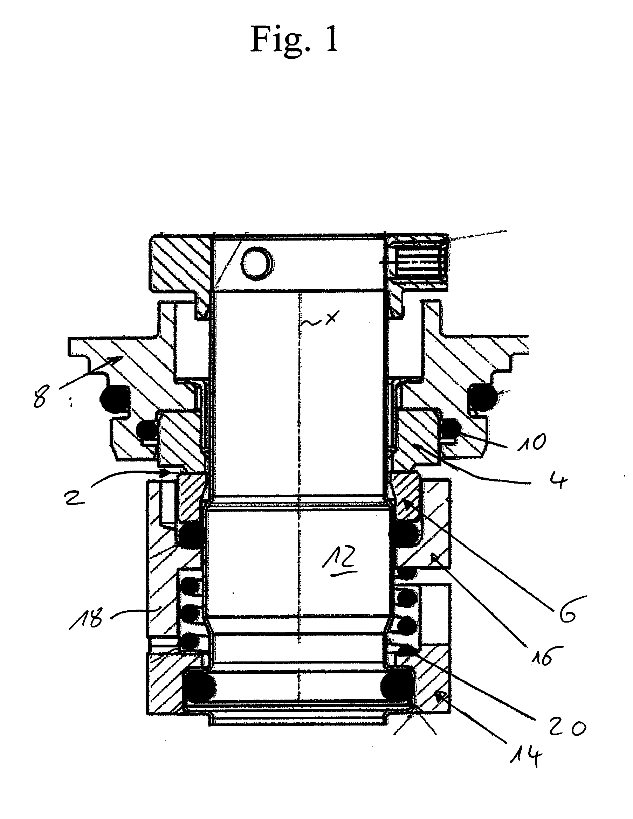

Fig. 1 zeigt den Einsatz der erfindungsgemäßen Gleitringdichtung 2, welcher aus zwei Dichtelementen 4 und 6 gebildet ist, welche mit ihren Dichtflächen gleitend aneinander anliegen. Das Dichtelement 4 bildet einen stationären Dichtring, welcher fest in einem Gehäuse 8, beispielsweise einem Pumpengehäuse gehalten ist. Gegenüber dem Gehäuse 8 ist das Dichtelement 4 mittels eines O-Ringes 10 abgedichtet.

Das zweite Dichtelement 6 ist ein bewegliches Dichtelement bzw. ein beweglicher Dichtring, welcher sich gemeinsam mit der Welle 12 dreht. Dazu ist er über zwei Halteringe 14, 16 drehfest mit der Welle 12 verbunden. Der erste Haltring 14 ist fest an der Welle 12 angebracht, d.h. sowohl in Drehrichtung als auch in axialer Richtung an der Welle 12 fixiert. Der zweite Haltering 16 ist über Vorsprünge 18 zur Drehmomentübertragung mit dem ersten Haltering 14 formschlüssig in Eingriff, gleichzeitig aber axial in Richtung der Drehachse X beweglich auf der Welle 12 gelagert. Der Haltering 16 ist ebenfalls formschlüssig mit dem zweiten Dichtelement 6 in Eingriff, sodass das Dichtelement 6 sich gemeinsam mit dem zweiten Haltering 16 dreht. Dazu greift das Dichtelement 6 im gezeigten Beispiel mittels radialer Auskragungen in korrespondierende Ausnehmungen des Halteringes 16 ein. Der Haltring 16 ist über eine Federelement 20 in Form einer Druckfeder an dem ersten Haltering 14 axial abgestützt, sodass das Federelement 20 den Haltering 16 axial gegen das zweite Dichtelement und somit das zweite Dichtelement 6 axial gegen das erste Dichtelement 4 drückt, sodass die Dichtflächen der beiden Dichtelemente 4, 6 in gleitender Anlage gehalten werden.

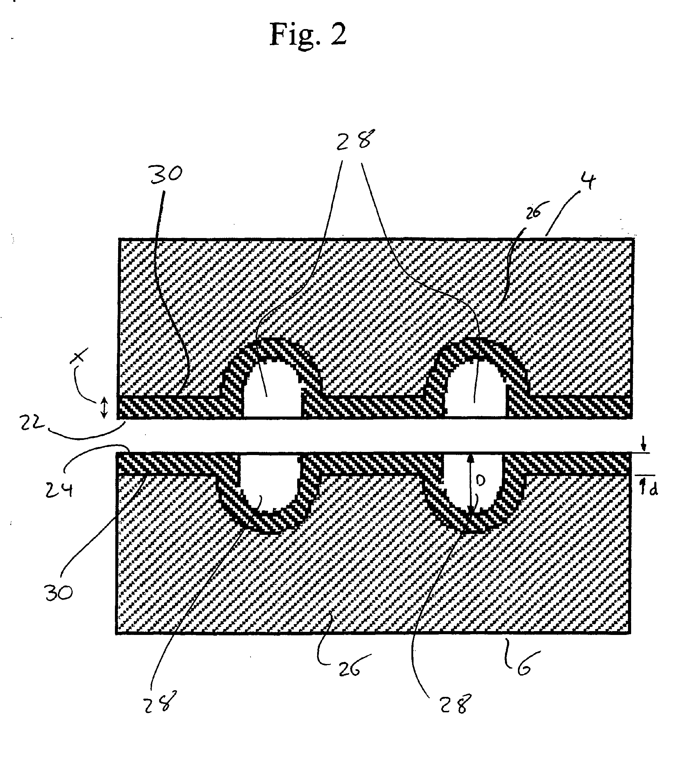

Erfindungsgemäß sind die Dichtflächen 22 und 24 der Dichtelemente 4 und 6, welche miteinander in Anlage kommen, beschichtet ausgebildet, wie in Fig. 2 schematisch gezeigt. Die Dichtelemente 4 und 6 bestehen jeweils aus einer Tragschicht bzw. einem Tragelement 26. Im gezeigten Beispiel ist das Tragelement 26 als Keramikring ausgebildet. An der Oberfläche, welche die Dichtflächen 22 und 24 bilden sollen, sind die Tragelemente 26 strukturiert ausgebildet, d.h. sie weisen Vertiefungen 28 in der Oberfläche auf. Diese sind vorzugsweise gleichmäßig über die Oberfläche verteilt und dienen dazu Wasser oder ein anderes zu förderndes Fluid aufzunehmen, welches von außen durch den Spalt zwischen den Dichtelementen 4 und 6 in die Gleitringdichtung eindringt. Dieses Wasser bzw. Fluid dient der Kühlung bzw. Schmierung der Dichtung. Um eine hohe Verschleißfestigkeit zu erreichen sind die Tragelemente 26 mit einer Deckschicht 30 aus Diamant beschichtet. Wie in Fig. 2 zu erkennen, sind die Deckschichten 30 mit im Wesentlichen konstanter Dicke über die gesamten Dichtflächen 22 und 24 ausgebildet. So bleiben an der Oberfläche der Deckschicht 30 auch die Vertiefungen 28 erhalten, d.h. die Strukturierung der Dichtflächen 26 zeichnet sich auch in der Oberfläche der Deckschichten 30 ab.

Im hier gezeigten Beispiel weisen die Vertiefungen 28 eine Tiefe D auf, welche größer als die Dicke d der Deckschicht 30 ist. Die Deckschicht 30 bedeckt dabei auch die Oberfläche der Vertiefungen 28 vollständig mit in etwa konstanter Dicke.

Die Vertiefungen 28 in dem Tragelement 26 können beispielsweise durch Laser eingebracht werden. Die aufgetragene Diamantschicht ist vorzugsweise polykristalliner Diamant, welcher beispielsweise im CVD-Verfahren (chemische Aufdampfung) auf das Tragelement bzw. die Tragschicht 26 aufgebracht ist. Dabei hat die Deckschicht im gezeigten Beispiel vorzugsweise eine Dicke zwischen 4 µm und 20 µm. Die Korngröße in der Deckschicht ist bevorzugt kleiner als 5 µm. Die Vertiefungen 28 bilden vorzugsweise 5% bis 30% der Oberfläche der Tragschicht 26 und haben vorzugsweise einen Durchmesser zwischen etwa 20 µm und 150 µm.

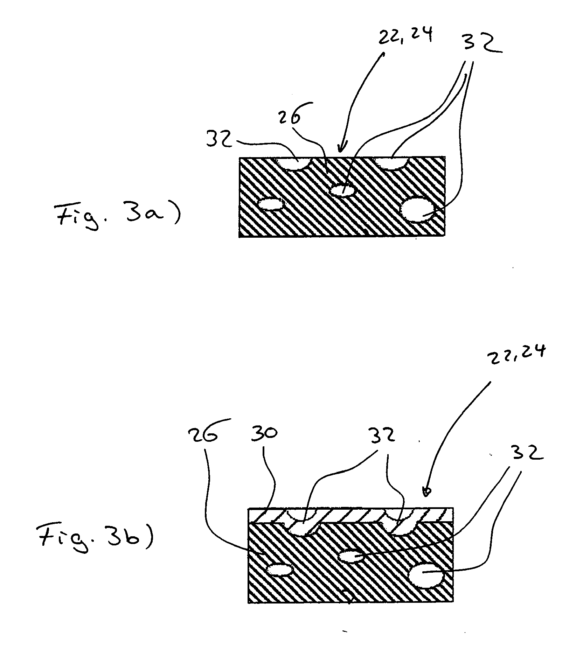

Anstatt das Tragelement 26 durch nachträgliche mechanische oder thermische Bearbeitung mit den Vertiefungen 28 zu versehen, kann auch ein Tragelement 26 aus einem porösen Material verwendet werden, wie anhand der Figuren 3a und 3b erläutert. Das Tragelement 26 ist in diesem Falle aus einem porösen Keramikmaterial ausgebildet, welches Poren 32 aufweist. Diese sind vorzugsweise gleichmäßig im Inneren des Materials verteilt. Ein Teil dieser Poren 32 ist zur Oberfläche hin geöffnet, d.h. auch zu der Oberfläche, welche die Dichtfläche 22, 24 bildet. Dort bilden die Poren 32 dann Vertiefungen, welche den Vertiefungen 28 gemäß dem Beispiel in Fig. 2 entsprechen. Wenn auf diese Oberfläche dann eine Deckschicht 30 aus Diamant mit konstanter Dicke aufgebracht wird, zeichnen sich diese Poren 32 ebenfalls an der Oberfläche der Deckschicht 30 ab und bilden somit eine Struktur ähnlich der, wie sie auch bei dem Ausführungsbeispiel gemäß Fig. 2 erreicht wird.

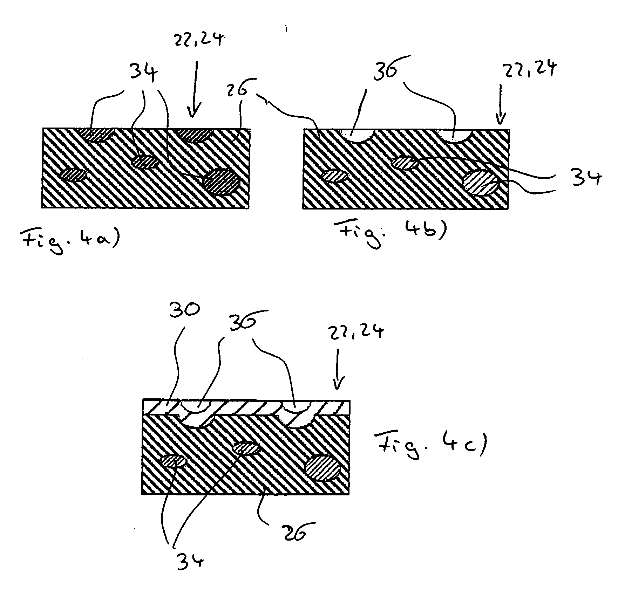

Die Poren in der Oberfläche des Tragelements 26 können beispielsweise auch durch ein Verfahren, wie es anhand der Figuren 4a bis 4c schrittweise gezeigt ist, ausgebildet werden. Gemäß diesem Verfahren wird ein Tragelement 26 aus einem Keramikmaterial mit Einschlüssen 34 verwendet. Ein Teil dieser Einschlüsse 34 liegt in der Oberfläche, welche die Dichtfläche 22, 24 bildet. Bei den Einschlüssen 34 kann es sich beispielsweise um Graphit handeln, welches in ein Keramikmaterial eingeschlossen ist. Durch Ätzen kann dieses Graphit an den zur Oberfläche hin geöffneten Einschlüssen abgetragen werden, sodass dort, wie in Fig. 4b gezeigt, Vertiefungen 36 entstehen. Diese entsprechen den Vertiefungen 28, wie sie anhand von Fig. 2 erläutert wurden. Anschließend wird, wie in Fig. 4c gezeigt ist, eine Deckschicht 30 aus Diamant, wie vorangehend anhand der Figuren 2 und 3 erläutert, aufgetragen. Auch hier wird eine Deckschicht 30 von im Wesentlichen konstanter Dicke aufgetragen, sodass sich die Vertiefungen 36 auch an der Oberfläche der Deckschicht 30, welche die Dichtflächen 22, 24 bilden, abzeichnen.

Hinsichtlich der Ausführungsbeispiele in Figuren 3 und 4 ist zu verstehen, dass die dort beschriebene Ausgestaltung sowohl für das Dichtelement 4 als auch für das Dichtelement 6 Verwendung finden kann.

### Bezugszeichenliste

- 2 -: Gleitringdichtung
- 4, 6 -: Dichtelement
- 8 -: Gehäuse
- 10 -: O-Ring
- 12 -: Welle
- 14, 16 -: Haltering
- 18 -: Axialer Vorsprung
- 20 -: Federelement
- 22, 24 -: Dichtflächen
- 26 -: Tragelement
- 28 -: Vertiefungen
- 30 -: Deckschicht
- 32 -: Poren
- 34 -: Einschlüsse
- 36 -: Vertiefungen

- X -: Längs- bzw. Drehachse
- D -: Tiefe der Vertiefungen 28
- d -: Dicke der Deckschicht

## Patentansprüche

1. Gleitringdichtung (2) mit zumindest einem ersten festen Dichtelement (4) und einem zweiten gemeinsam mit einer Welle rotierendem Dichtelement (6), **dadurch gekennzeichnet, dass** zumindest eines der Dichtelemente (4, 6) eine Dichtfläche (22, 24) aufweist, welche aus einer an der Oberfläche strukturierten Tragschicht (26) und einer auf der Tragschicht (26) derart aufgebrachten diamanthaltigen Deckschicht (30) gebildet ist, dass die Oberfläche der Deckschicht aufgrund der Strukturierung der Tragschicht (26) entsprechend strukturiert ist.

2. Gleitringdichtung nach Anspruch 1, **dadurch gekennzeichnet, dass** das erste Dichtelement (4) eine erste Dichtfläche (22) aufweist und dass das zweite Dichtelement (6) eine zweite Dichtfläche (24) aufweist, welche jeweils aus einer an der Oberfläche strukturierten Tragschicht (26) und einer auf der Tragschicht (26) derart aufgebrachten diamanthaltigen Deckschicht (30) gebildet sind, dass die Oberfläche der Deckschicht (30) aufgrund der Strukturierung der Tragschicht (26) entsprechend strukturiert ist.

3. Gleitringdichtung nach einem der vorangehenden Ansprüche, **dadurch gekennzeichnet, dass** die Tragschicht (26) durch Oberflächenbearbeitung strukturiert ist.

4. Gleitringdichtung nach einem der vorangehenden Ansprüche, **dadurch gekennzeichnet, dass** die Tragschicht (26) aus einem porösen Material besteht.

5. Gleitringdichtung nach einem der vorangehenden Ansprüche, **dadurch gekennzeichnet, dass** die Tragschicht (26) aus einem Keramikmaterial, vorzugsweise Siliziumkarbid oder Wolframkarbid besteht.

6. Gleitringdichtung nach einem der vorangehenden Ansprüche, **dadurch gekennzeichnet, dass** die Strukturierung der Tragschicht (26) in Form einer Vielzahl von Vertiefungen (28, 32, 36) an der Oberfläche der Tragschicht (26) ausgebildet ist.

7. Gleitringdichtung nach Anspruch 6, **dadurch gekennzeichnet, dass** die Vertiefungen (28, 32, 36) gleichmäßig über die Oberflöche verteilt sind.

8. Gleitringdichtung nach Anspruch 6 oder 7, **dadurch gekennzeichnet, dass** die Vertiefungen (28, 32, 36) 5 bis 30% der Oberfläche der Tragschicht (26) bedecken.

9. Gleitringdichtung nach einem der Ansprüche 6 bis 8, **dadurch gekennzeichnet, dass** die Vertiefungen (28, 32, 36) einen Durchmesser zwischen 20 und 150µm aufweisen.

10. Gleitringdichtung nach einem der vorangehenden Ansprüche, **dadurch gekennzeichnet, dass** die Deckschicht (30) aus polykristallinem Diamant besteht.

11. Gleitringdichtung nach einem der Ansprüche 2 bis 10, **dadurch gekennzeichnet, dass** die erste und die zweite Dichtfläche (22, 24) unterschiedlich strukturiert und/oder beschichtet sind.

12. Gleitringdichtung nach einem der vorangehenden Ansprüche, **dadurch gekennzeichnet, dass** sie als Wellendichtung in einer Pumpe eingesetzt ist.

13. Verfahren zum Herstellen einer Gleitringdichtung nach einem der vorangehenden Ansprüche, **dadurch gekennzeichnet, dass** zur Ausbildung einer Dichtfläche (22, 24) zunächst ein Tragelement (26) mit einer strukturierten Oberfläche bereitgestellt wird und diese strukturierte Oberfläche anschließend derart gleichmäßig mit Diamant beschichtet wird, dass an der Oberfläche der so gebildeten diamanthaltigen Deckschicht (30) die Strukturierung der Oberfläche des Tragelementes (26) erhalten bleibt.

14. Verfahren nach Anspruch 13, **dadurch gekennzeichnet, dass** die Strukturierung der Oberfläche des Tragelementes (26) durch Ätzen, Laser- und/oder Elektronenstrahlbearbeitung erfolgt.

15. Verfahren nach Anspruch 13 oder 14, **dadurch gekennzeichnet, dass** die Strukturierung der Oberfläche des Tragelementes (26) in der Weise erzeugt wird, dass das Tragelement (26) aus einem Material mit Einschlüssen (34) gefertigt wird und die Einschlüsse (34) an der Oberfläche durch Ätzen abgetragen werden.
